# EUROPEAN PATENT SPECIFICATION

(11) **EP 4 398 694 B1**
(45) Date of publication and mention of the grant of the patent: **14.01.2026**
(21) Application number: 23191539.8
(22) Date of filing: 15.08.2023
(51) Int. Cl.: H10B 41/27, H10B 41/50, H10B 43/27, H10B 43/50

(54) **SEMICONDUCTOR DEVICE HAVING COMMON SOURCE LINE LAYER, ELECTRONIC SYSTEM INCLUDING THE SAME, AND RELATED METHOD OF MANUFACTURING SEMICONDUCTOR DEVICE**
HALBLEITERBAUELEMENT MIT GEMEINSAMER SOURCE-LEITUNGSSCHICHT, ELEKTRONISCHES SYSTEM DAMIT UND ZUGEHÖRIGES VERFAHREN ZUR HERSTELLUNG EINES HALBLEITERBAUELEMENTS
DISPOSITIF À SEMI-CONDUCTEUR AYANT UNE COUCHE DE LIGNE DE SOURCE COMMUNE, SYSTÈME ÉLECTRONIQUE LE COMPRENANT ET PROCÉDÉ ASSOCIÉ DE FABRICATION DE DISPOSITIF À SEMI-CONDUCTEUR

(30) Priority: 09.01.2023 KR 20230002900
(43) Date of publication of application: 10.07.2024
(73) Proprietor: Samsung Electronics Co., Ltd., Suwon-si, Gyeonggi-do 16677 (KR)
(72) Inventor: KIM, Jiwon, Suwon-si (KR); LEE, Ahreum, Suwon-si (KR); KWON, Joonyoung, Suwon-si (KR); KIM, Dohyung, Suwon-si (KR); KIM, Junhyoung, Suwon-si (KR); SUNG, Sukkang, Suwon-si (KR)
(74) Representative: Marks & Clerk LLP

(56) References cited:
- US-A1- 2021 225 758
- US-A1- 2022 102 306

## Description

### 1. Technical Field

The present invention relates to a semiconductor device and to a method of manufacturing the semiconductor device. The disclosure relates to a semiconductor device with a common source line layer, an electronic system including the same, and a method of manufacturing semiconductor device.

### 2. Background

Recently, vertically stacked memory devices in which memory cells are vertically stacked on the surface of the substrate are developed. As the number of the stacked memory cells included in the vertically stacked memory devices increases, it is not easy to form the memory cells and a wire structure for connecting them.

We refer to:
- US2022/102306 A1 (Ahn Jae Ho; 31.3.22), which relates to a non-volatile memory device, system including the same and method of fabricating the same, and discloses such a device including a plurality of word lines stacked sequentially on a ground selection line.
- patent application publication US2021/225758 A1 (Lee Name Jae, 227.21, which relates to a semiconductor memory device and manafacturing method thereof, and discloses such a device including bit lines and a common source line spaced apart from each other in a first level.

### SUMMARY

According to a first aspect of the present invention there is provided a semiconductor devices according to claim 1. According to second aspect of the present invention, there is provided a method of manufacturing the semiconductor device, according to claim 12.

Preferred embodiments are defined by the dependent claims.

### BRIEF DESCRIPTION OF THE DRAWINGS

FIG. 1 shows a layout view of a common source line layer of a semiconductor device according to an embodiment.
FIG. 2 shows a cross-sectional view of a semiconductor device with respect to a line II-II of FIG. 1 according to an embodiment.
FIG. 3 to FIG. 8 show intermediate processes of a method for manufacturing a semiconductor device according to an embodiment.
FIG. 9 shows an intermediate process of a method for manufacturing a semiconductor device according to another embodiment.
FIG. 10 shows a data storage system including a semiconductor device according to an embodiment.
FIG. 11 shows a perspective view of a data storage system including a semiconductor device according to an embodiment.

### DETAILED DESCRIPTION

The present disclosure may provide a semiconductor device with a simple wiring structure.

The present disclosure may simplify a process for manufacturing a semiconductor device.

The present disclosure are not limited by the above-described technical object, and the scope of the present disclosure will be clearly comprehended to a person of ordinary skill in the art by the following disclosure.

According to the present invention, a semiconductor device includes a cell region in which a channel structure is disposed and memory cells arranged in three dimensions are disposed, a cell contact region in which a cell contact plug is disposed, a common source line contact region in which a common source line contact plug is disposed, an input and output contact region in which an input and output contact plug is disposed, a word line cut region configured to separate word lines of the cell region from word lines of a neighboring cell region, a common source line layer configured to connect the channel structure and the common source line contact plug, and an input and output pad connected to the input and output contact plug. The common source line layer and the input and output pad are disposed at the same vertical level.

The invention provides a semiconductor device including: a cell region including: a channel structure penetrating through a plurality of word lines, and memory cells connected to the plurality of word lines and arranged in three dimensions; a cell contact region in which a cell contact plug connected to a word line of the cell region is disposed; a common source line contact region in which a common source line contact plug is disposed; an input and output contact region in which an input and output contact plug connected to a circuit of the semiconductor device is disposed; a word line cut region separating the word line of the cell region from a word line of a neighboring cell region; a common source line layer connecting the channel structure of the cell region and the common source line contact plug; and an input and output pad as an external pad of the semiconductor device connected to the input and output contact plug. The common source line layer and the input and output pad are disposed at the same vertical level. Each of the common source line layer and the input and output pad includes the same material.

Moreover, the semiconductor device according to the present invention further comprises an isolated pad disposed in the cell contact region and connected to the cell contact plug, wherein the isolated pad is disposed at the same vertical level as the common source line layer, and wherein the isolated pad and the common source line layer comprise the same material.

Another embodiment of the present disclosure provides a method of manufacturing a semiconductor device including: forming a sacrificial layer in a trench formed in a silicon substrate; forming a memory cell structure on a cell region of the silicon substrate on which the sacrificial layer is formed; removing the silicon substrate, forming a first insulation layer to cover the sacrificial layer, and partially removing the first insulation layer to expose an upper surface of the sacrificial layer; removing the sacrificial layer; and forming a metal layer filling a space where the sacrificial layer is removed, and patterning the same. The forming of the memory cell structure includes forming a channel structure penetrating through a plurality of word lines, forming a cell contact plug connected to a word line of the plurality of word lines, forming a common source line contact plug connected to the channel structure, forming an input and output contact plug connected to a circuit of the semiconductor device, and forming a word line cut insulator separating the plurality of word lines of the cell region from word lines of a neighboring cell region of the silicon substrate.

The semiconductor device according to an embodiment of the present disclosure may have the common source line layer made of a metal on the rear surface, thereby having simplified the wiring structure.

The method for manufacturing a semiconductor device according to an embodiment of the present disclosure may simultaneously form the input and output pad, the isolated pad of the cell contact region, and the metal common source line layer, thereby simplifying the process for manufacturing a semiconductor device.

The present disclosure will be described more fully hereinafter with reference to the accompanying drawings, in which embodiments are shown. As those skilled in the art would realize, the described embodiments may be modified in various different ways, all without departing from the scope of the present invention which is defined by the claims.

The drawings and the descriptions are to be considered as illustrative and not as restrictive. Throughout the specification, the same reference numbers indicate the same constituent elements.

Parts that are of less interest or of less relevance to the description are omitted to clearly describe the present disclosure, and like reference numerals designate like elements throughout the specification. The thicknesses of layers, films, panels, regions, etc., are enlarged for clarity. The thicknesses of some layers and areas are exaggerated.

The singular forms are intended to include the plural forms as well, unless the context clearly indicates otherwise.

In the specification and the claims, the term "and/or" is intended to include arbitrary combinations of the terms "and" and "or" for the purposes of meaning and interpretation. For example, the expression of "A and/or B" may be understood to signify "A, B, or A and B".

In the specification and claims, the phrase "at least one of" is intended to include the meaning of "at least one selected from the group of," for the purpose of meaning and interpretation. For example, "at least one of A and B" may be understood to signify "A, B, or A and B".

Terms such as first, second, and the like will be used only to describe various constituent elements, and are not to be interpreted as limiting these constituent elements. The terms are only used to differentiate one constituent element from other constituent elements. For example, a first constituent element could be termed a second constituent element, and similarly, a second constituent element could be termed as a first constituent element, without departing from the scope of the present disclosure.

When an element, such as a layer, a film, a region, or a substrate is described to be "above" another element, it may be directly above another element or there may be an intermediate element. In contrast, when a first element is described to be "directly above" a second element, there is no intermediate element. Throughout the specification, the term "above" a target must be "understood as being disposed above or below the target element, and does not necessarily signify "above" with respect to an opposite direction of gravity.

For example, spatially relative terms "below" or "above" may be used to facilitate the description of the relationship of one element or a constituent element to other constituent elements as shown in the drawings. The spatially relative terms are intended to include other directions in use or operation in addition to the directions shown in the drawings. For example, when the device shown in the drawing is flipped, the device disposed below another device may be disposed "above" the other device. Therefore, the term "below" may include lower and upper positions. The device may also be oriented in other directions, the spatially relative term may be analyzed differently depending on the directions.

When an element (or region, layer, portion, etc.) is described to be "connected" or "combined" to another element in the specification, it may be directly disposed, connected, or combined on the above-noted other element, or an element may be disposed therebetween.

The term "connected to" or "combined to" may include physical or electrical connections or combinations.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

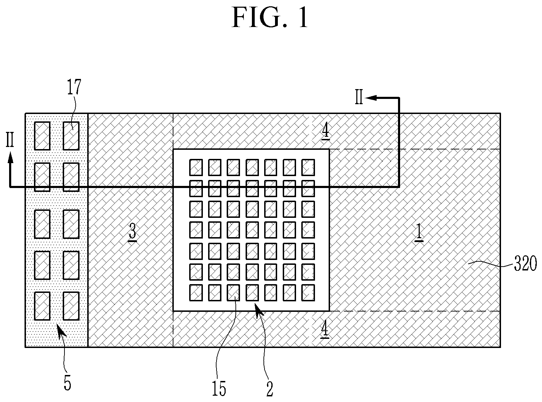

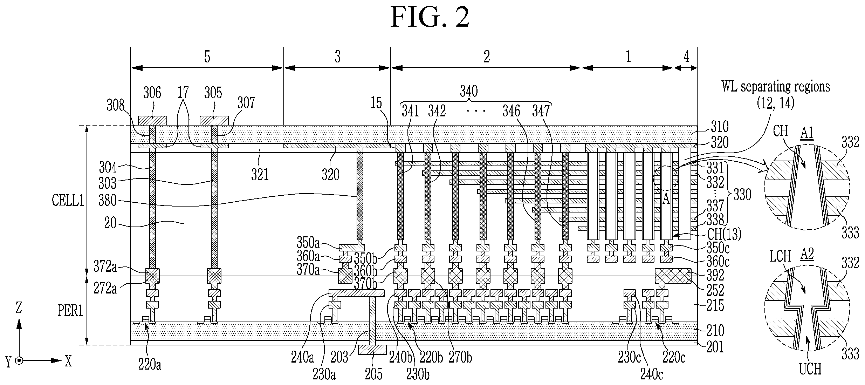

FIG. 1 shows a layout view of a common source line layer of a semiconductor device according to an embodiment, and FIG. 2 shows a cross-sectional view of a semiconductor device with respect to a line II-II of FIG. 1 according to an embodiment.

Referring to FIG. 1, the semiconductor device includes a cell region 1 in which memory cells are disposed in a three dimension (3D), a cell contact region 2 in which a cell contact plug and an isolated pad are disposed, a common source line contact region 3 in which a common source line contact plug is disposed, an input and output contact region 5 in which an input and output contact plug and an input and output pad are disposed, and a word line cut region 4 separating word lines of the cell region 1 from word lines of a neighboring cell region 1. The cell contact region 2 may be surrounded by the cell region 1, the common source line contact region 3, and the word line cut region 4, and the input and output contact region 5 may be disposed on one side of the common source line contact region 3.

A common source line layer 320 may be integrally formed and connected throughout the cell region 1, the common source line contact region 3, and the word line cut region 4. Respective input and output pads 17 may be disposed to be separated from each other in the input and output contact region 5, and isolated pads 15 connected to respective cell contact plugs may be disposed to be separated from each other in the cell contact region 2. The common source line layer 320, the input and output pads 17, and the isolated pads 15 are disposed at the same vertical level. Each of the common source line layer 320, the input and output pads 17, and the isolated pads 15 include the same material. For example, each of the common source line layer 320, the input and output pads 17, and the isolated pads 15 may include at least one of metals such as tungsten, titanium, tantalum, platinum, cobalt, copper, or aluminum as a major component. By the term 'major component' of an element, it is meant the component that makes up more than half of the entire weight of the element.

Referring to FIG. 2, the semiconductor device may have a chip to chip (C2C) structure. The semiconductor device may be a memory device. Here, the C2C structure may signify manufacturing at least one upper chip including a cell region CELL and a lower chip including a peripheral circuit region PERI, and connecting the at least one upper chip and the lower chip by a bonding method. For example, the bonding method may represent a method for electrically or physically connecting a bonding metal pattern formed on an uppermost metal layer of an upper chip and a bonding metal pattern formed on an uppermost metal layer of a lower chip. For another example, when the bonding metal patterns are made of copper (Cu), the bonding method may be a Cu-Cu bonding method. For another example, the bonding metal patterns may be made of aluminum (Al) or tungsten (W).

The memory device may include at least one upper chip including a cell region. For example, the memory device may be realized to include two upper chips. This is, however, for illustrative purposes, and the number of the upper chips is not limited thereto.

When the memory device is manufactured by the bonding method, the memory device may be manufactured by manufacturing the upper chip including a cell stack (or, a cell stack region) CELL1 and the lower chip including a peripheral circuit region PERI, and connecting the upper chip and the lower chip according to the bonding method. The upper chip may be inverted and may be connected to the lower chip by the bonding method. Hereinafter, the top and bottom of the upper chip is defined as before the upper chip is inverted. In other words, in FIG. 2, the top of the lower chip refers to the top defined in the +Z-axis direction, and the top of the upper chip refers to the top defined in the -Z-axis direction.

The peripheral circuit region PERI may include a first substrate 210 and a plurality of circuit elements 220a, 220b, and 220c formed on the first substrate 210. An interlayer insulating layer 215 including one or more insulation layers may be provided on the circuit elements 220a, 220b, and 220c, and a plurality of metal wires for connecting the circuit elements 220a, 220b, and 220c may be provided in the interlayer insulating layer 215. For example, the metal wires may include first metal wires 230a, 230b, and 230c connected to the circuit elements 220a, 220b, and 220c, and second metal wires 240a, 240b, and 240c disposed on the first metal wires 230a, 230b, and 230c. The metal wires may be made of at least one of various conductive materials. For example, the first metal wires 230a, 230b, and 230c may be made of tungsten with relatively high electrical resistivity, and the second metal wires 240a, 240b, and 240c may be made of copper with relatively low electrical resistivity.

Although only the first metal wires 230a, 230b, and 230c and the second metal wires 240a, 240b, and 240c are shown and described herein, at least one additional metal wiring may be formed on the second metal wires 240a, 240b, and 240c. In this case, the second metal wires 240a, 240b, and 240c may be made of aluminum. At least part of the additional metal wire formed on the second metal wires 240a, 240b, and 240c may be made of copper that has lower electrical resistivity than aluminum of the second metal wires 240a, 240b, and 240c.

The interlayer insulating layer 215 may be disposed on the first substrate 210, and may include an insulating material such as a silicon oxide or a silicon nitride.

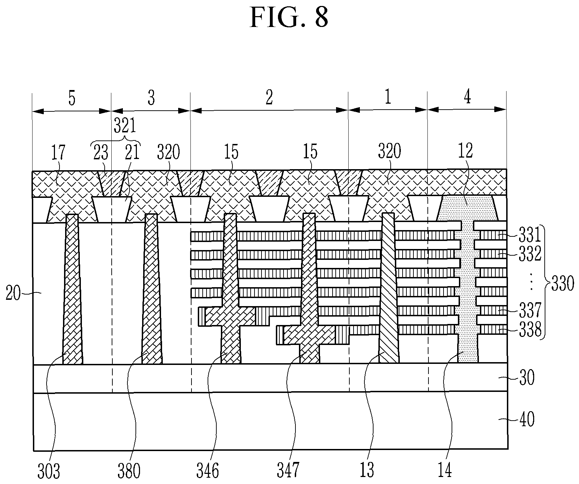

The cell stack CELL1 may include at least one memory block. The cell stack CELL1 may include a second substrate 310 and a common source line layer 320. The common source line layer 320 may be made of a metal such as tungsten, titanium, tantalum, platinum, cobalt, copper, or aluminum, and may be disposed in or to be inserted into the insulation layer 321. The insulation layer 321 may be formed in two layers, and may be two layers of oxide or a mixture of oxide and nitride. The input and output pads 17 of the input and output contact region 5 and the isolated pads 15 of the cell contact region 2, which are made of the same material as the common source line layer 320, may be disposed within the insulation layer 321. The common source line layer 320, the input and output pads 17, and the isolated pads 15 may have upper portions and lower portions that have different planar shapes. For example, the common source line layer 320, the input and output pads 17, and the isolated pads 15 may have wide lower portions and narrow upper portions. The common source line layer 320 may include a lower portion integrally formed throughout the cell region 1, the common source line contact region 3, and the word line cut region 4 and an upper portion protruding at portions that correspond to a common source line contact plug 380 and channel structures CH. Cross-sectional shapes of the common source line layer 320, the input and output pads 17, and the isolated pads 15 will be described below with reference to FIG. 8.

On the second substrate 310, a plurality of word lines 330 (331-338) may be stacked along a direction perpendicular to the top surface of the second substrate 310 (z-axis direction). String selection lines and a ground selection line may be disposed above and below the word lines 330, and the word lines 330 may be disposed between the string selecting lines and the ground selecting line. In an embodiment, one of the string selection lines may be the word line 331 and the ground selection line may be the word line 338. In this case, the word lines 330 (332-337) may be disposed between the string selecting line (331) and the ground selecting line (338).

The second substrate 310 may function as a supporter of the cell stack CELL1, or it may be an insulation layer covering the common source line layer 320, the input and output pads 17, and the isolated pads 15.

The plurality of channel structures CH may be formed on the cell stack CELL1.

As shown in a region A1, the channel structures CH may extend in a direction perpendicular to an upper surface of the second substrate 310 and may penetrate through the word lines 330, the string selecting lines, and the ground selecting line. The channel structures CH may include a data storage layer, a channel layer, and a fill insulation layer. The channel layer may be electrically connected to a first metal wire 350c and a second metal wire 360c. For example, the second metal wire 360c may be a bit line, and may be connected to the channel structures CH through the first metal wire 350c. The second metal wire 360c that is a bit line may extend in a first direction (Y-axis direction) in parallel to the upper surface of the second substrate 310.

As shown in a region A2, the channel structures CH may include a lower channel LCH and an upper channel UCH connected to each other. For example, the channel structures CH may be formed by a process for the lower channel LCH and a process for the upper channel UCH. The lower channel LCH may extend in a direction perpendicular to the upper surface of the second substrate 310 and may penetrate through the lower word lines 331 and 332. The lower channel LCH may include a data storage layer, a channel layer, and a buried insulation layer, and may be connected to the upper channel UCH. The upper channel UCH may penetrate through the upper word lines 333 to 338. The upper channel UCH may include a data storage layer, a channel layer, and a buried insulation layer, and the channel layer of the upper channel UCH may be electrically connected to the first metal wire 350c and the second metal wire 360c. As a length of the channel in the first direction increases, it may be difficult to form a channel with a constant width because of the process. The memory device according to an embodiment may have channels having improved width uniformity with a lower channel (LCH) and an upper channel (UCH) formed in a sequential process.

As shown in the region A2, when each of the channel structures CH is formed to include the lower channel LCH and the upper channel UCH, the word line disposed near a boundary of the lower channel LCH and the upper channel UCH may be a dummy word line. For example, the word line 332 and the word line 333 forming the boundary of the lower channel LCH and the upper channel UCH may be dummy word lines. In this case, no data may be stored in the memory cells connected to the dummy word line. In another way, the number of pages that correspond to the memory cells connected to the dummy word line may be less than the number of pages that correspond to the memory cells connected to a general (or, a normal) word line. A voltage level applied to the dummy word line may be different from a voltage level applied to the general word line, thereby reducing effects given by the non-uniform channel width between the lower channel LCH and the upper channel UCH to the operation of the memory device.

It is shown in the region A2 that the number of the lower word lines 331 and 332 penetrated by the lower channel LCH is less than the number of the upper word lines 333 to 338 penetrated by the upper channel UCH. However, the present disclosure is not limited thereto, for example, the number of the lower word lines penetrating the lower channel LCH may be equal to or greater than the number of the upper word lines penetrated by the upper channel UCH.

An upper metal pattern 252 may be formed in an uppermost metal layer of the peripheral circuit region PERI of the upper portion of the channel structures CH, and an upper metal pattern 392 having the same shape as the upper metal pattern 252 may be formed in the uppermost metal layer of the cell stack CELL1. The upper metal pattern 392 of the cell stack CELL1 may be electrically connected to the upper metal pattern 252 of the peripheral circuit region PERI by a bonding method. The bit line 360c may be electrically connected to a page buffer included in the peripheral circuit region PERI. For example, some of the circuit elements 220c of the peripheral circuit region PERI may provide the page buffer.

Referring to FIG. 2, the word lines 330 of the cell stack CELL1 may extend in the second direction (X-axis direction) parallel to the upper surface of the second substrate 310, and may be connected to a plurality of cell contact plugs 340 (341 to 347). A first metal wire 350b and a second metal wire 360b may be sequentially connected to upper portions of the cell contact plugs 340 connected to the word lines 330. The cell contact plugs 340 may be connected to the peripheral circuit region PERI through an upper bonding metal 370b of the cell stack CELL1 and an upper bonding metal 270b of the peripheral circuit region PERI.

The isolated pads 15 made of the same material as the common source line layer 320 may be connected to the lower portion of the cell contact plugs 340.

The cell contact plugs 340 may be electrically connected to a row decoder included in the peripheral circuit region PERI. For example, some of the circuit elements 220b of the peripheral circuit region PERI provide the row decoder, and the cell contact plugs 340 may be electrically connected to the circuit elements 220b for providing the row decoder through the upper bonding metal 370b of the cell stack CELL1 and the upper bonding metal 270b of the peripheral circuit region PERI.

The upper bonding metal 370b may be formed on the cell stack CELL1 in the cell contact region 2, and the upper bonding metal 270b may be formed in the peripheral circuit region PERI. The upper bonding metal 370b of the cell stack CELL1 may be electrically connect to the upper bonding metal 270b of the peripheral circuit region PERI by a bonding method. The upper bonding metal 370b and the upper bonding metal 270b may be made of aluminum, copper, or tungsten.

An upper metal pattern 372a may be formed on the upper portion of the cell stack CELL1, and an upper metal pattern 272a may be formed on the upper portion of the peripheral circuit region PERI in the input and output contact region 5. The upper metal pattern 372a of the cell stack CELL1 may be connected to the upper metal pattern 272a of the peripheral circuit region PERI by a bonding method.

The common source line contact plugs 380 may be disposed in the common source line contact region 3. The common source line contact plugs 380 may be made of a conductive material such as a metal, a metal compound, or doped polysilicon. The common source line contact plug 380 may be electrically connected to the common source line layer 320. A first metal wire 350a and a second metal wire 360a may be sequentially stacked on the upper portion of the common source line contact plug 380.

External pads 205, 305, and 306 may be disposed in the input and output contact region 5 and the common source line contact region 3. Referring to FIG. 2, a lower insulation layer 201 may cover the lower surface of the first substrate 210, and a first external pad 205 may be formed on the lower insulation layer 201. The first external pad 205 may be connected to at least one of the circuit elements 220a disposed in the peripheral circuit region PERI through a first input and output contact plug 203, and may be separated from the first substrate 210 by the lower insulation layer 201. A lateral insulation layer may be disposed between the first input and output contact plug 203 and the first substrate 210 to electrically separate the first input and output contact plug 203 from the first substrate 210.

A second external pad 305 and/or a third external pad 306 may be disposed on the upper portion of the second substrate 310. The second external pad 305 may be connected to at least one of the circuit elements 220a disposed in the peripheral circuit region PERI through a first substrate plug 307, the input and output pad 17, and a second input and output contact plug 303, and the third external pad 306 may be connected to at least one of the circuit elements 220a disposed in the peripheral circuit region PERI through a second substrate plug 308, the input and output pad 17, and a third input and output contact plug 304.

Depending on embodiments, the first to third external pads 205, 305, and 306 may be selectively formed. For example, the memory device may be realized to include only the first external pad 205 disposed on the upper portion of the first substrate 210 or include only the second external pad 305 or the third external pad 306 disposed on the upper portion of the second substrate 310.

Depending on embodiments, the second substrate 310 may be omitted, and the input and output pad 17 may function as an external pad.

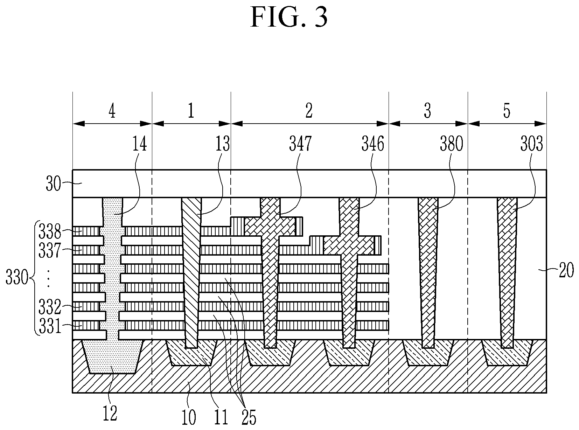

FIG. 3 to FIG. 8 show a method for manufacturing a semiconductor device according to an embodiment.

For better comprehension and ease of explanation, in FIGS. 3 through 8, metal wires and bonding metals on top of the channel structure (CH), which are not directly related to the content of the embodiment, are simplified and shown as one layer (superstructure layer 30), and the peripheral circuit region (PERI) is simplified and shown as one block (peripheral circuit block 40). That is, the portion in which the first metal wires 350a, 350b, 350c, second metal wires 360a, 360b, 360c, upper bonding metals 370a and 370b, upper metal patterns 372a and 392, and the like of FIG. 2 are formed is simplified to the superstructure layer 30, and the peripheral circuit region (PERI) is simplified to the peripheral circuit block 40. One 303 of the second and third input and output contact plugs 303 and 304, the common source line contact plug 380, two (346 and 347) of the cell contact plugs 340, the channel structure 13, and word line cut insulators 12 and 14 relating to the content of an embodiment are shown from among the many constituent elements of FIG. 2.

Referring to FIG. 3, a trench is formed on the silicon substrate 10 and the trench is filled with an aluminum oxide (AlO) to form a sacrificial layer 11. The silicon substrate 10 may be a silicon monocrystalline wafer or a polysilicon layer formed on a semiconductor wafer.

A word line interlayer insulating layer 25 and a sacrificial insulation layer are alternately stacked on the silicon substrate 10 on which the sacrificial layer 11 may be formed to form a preliminary stacking structure, and the preliminary stacking structure may be patterned according to photolithography and a trim process to thus form a stair structure in the cell contact region 2. An interlayer insulating layer 20 may be formed on the preliminary stacking structure and may be planarized, and the channel structure 13 penetrating the preliminary stacking structure and the interlayer insulating layer 20 may be formed. Openings penetrating the preliminary stacking structure and the interlayer insulating layer 20 are formed, and the sacrificial insulation layer is removed and the conductive material is filled through the openings to form the word lines 330. The openings may include an opening to be filled with the word line cut insulators 12 and 14 and an opening to be filled with the cell contact plug 340, the common source line contact plug 380, and the input and output contact plug 303. Word line cut insulators 12 and 14, a cell contact plug 340, a common source line contact plug 380, and an input and output contact plug 303 filling the opening may be formed. Formation of the cell contact plug 340, the common source line contact plug 380, and the input and output contact plug 303 may include removing the sacrificial layer and filling the conductive material. Lower ends of the channel structures 13, the cell contact plug 340, the common source line contact plug 380, and the input and output contact plug 303 may be disposed in the sacrificial layer 11. FIG. 2 and FIG. 3 show that the word line cut insulators 12 and 14 have a boundary separated from the interlayer insulating layer 20 or the insulation layer 25, and depending on embodiments, the word line cut insulators 12 and 14, the interlayer insulating layer 20, and the insulation layer 25 may be made of the same material, and the boundary among them may not be formed.

Referring to FIG. 2 and FIG. 3, the superstructure layer 30 including the first metal wires 350a, 350b and 350c, the second metal wires 360a, 360b and 360c, the upper bonding metals 370a and 370b, and the upper metal patterns 372a and 392, and the interlayer insulating layer insulating the same, may be formed.

Fabrication of these memory cell structures may be accomplished by a variety of known methods to fabricate vertical memory devices, of which detailed descriptions will be omitted. For example, the method disclosed in Korean Patent Application Publication No. 10-2020-0036503 may be applied.

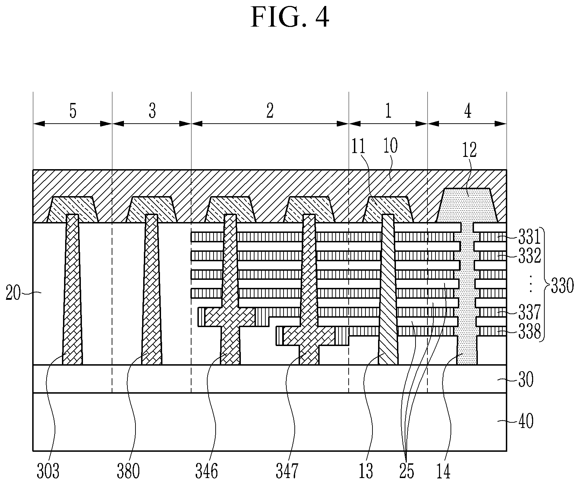

Referring to FIG. 4, the memory cell structure of FIG. 3 may be inverted and may be connected to the peripheral circuit block 40 by a bonding method.

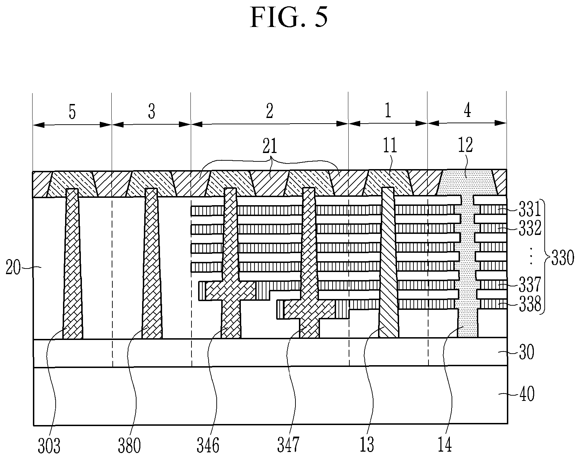

Referring to FIG. 5, the silicon substrate 10 is etched and removed, the oxide layer or the nitride layer is deposited to form an insulation layer 21, and a chemical mechanical polishing (CMP) process on the insulation layer 21 is progressed to thus expose the sacrificial layer 11. In this instance, the sacrificial layer 11 may be used as a stopping layer of the chemical mechanical polishing.

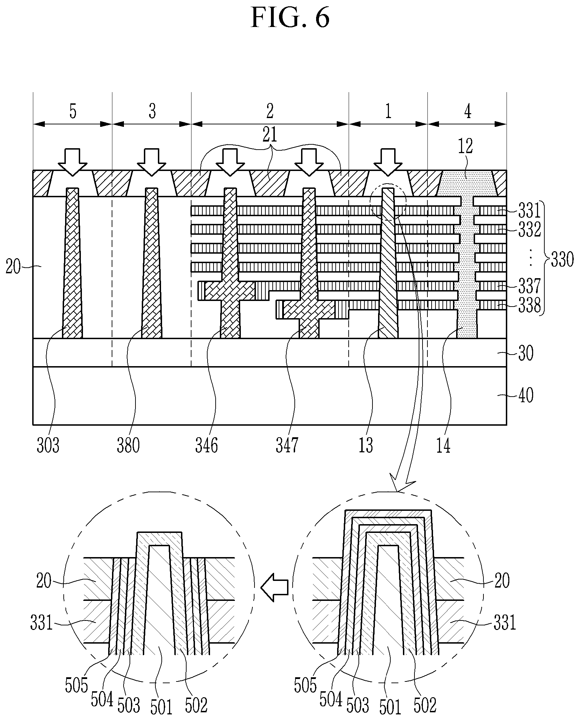

Referring to FIG. 6, the exposed sacrificial layer 11 is removed. Removal of the sacrificial layer 11 may include a dry etching process. An ONO (oxide layer 505/nitride layer 504/oxide layer 503) layer on the lower portion of the channel structure 13 exposed by removing the sacrificial layer 11 may be removed to expose a polysilicon layer 502 of the channel structure 13, and form a silicide at a surface of the exposed polysilicon layer 502. The silicide may be a nickel silicide.

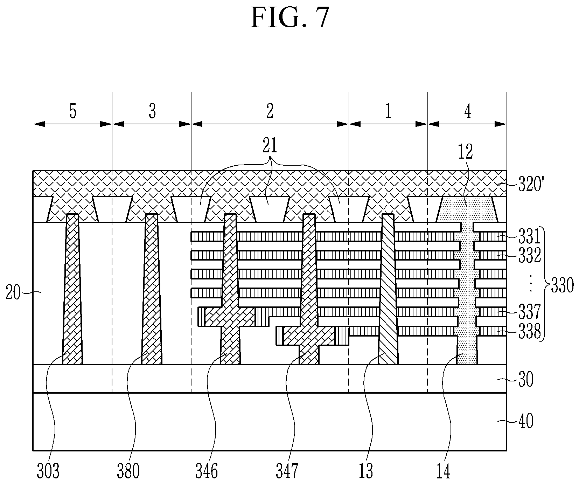

Referring to FIG. 7, a metal layer 320' is formed to fill the space from which the sacrificial layer 11 is removed. The metal layer 320' may, for example, include a metal with low electrical resistance, such as tungsten, titanium, tantalum, platinum, cobalt, copper, or aluminum.

Referring to FIG. 8, the metal layer 320' may be patterned to form the common source line layer 320, the isolated pads 15, and the input and output pads 17, and a space among the common source line layer 320, the isolated pad 15, and the input and output pad 17 may be filled with an insulation layer 23. Patterning of the metal layer 320' may include a photolithography process. The insulation layer 23 may include a silicon oxide or a silicon nitride. Formation of the insulation layer 23 may include depositing an insulation layer, etching back, CMP, or a photolithography process. Depending on embodiments, the process for forming an insulation layer 23 may be omitted.

Referring to FIG. 1 and FIG. 8, the common source line layer 320 may be integrally formed and electrically connected across the cell region 1, the common source line contact region 3, and the word line cut region 4. For example, the common source line layer 320 connected to the common source line contact plug 380 may be connected to the common source line layer 320 connected to the channel structure 13 through the common source line layer 320 of the word line cut region 4.

Referring to FIG. 8, each of the common source line layer 320, isolation pads 15, and input and output pads 17 may include a first portion filling the area where the sacrificial layer 11 is removed and a second portion formed over the first portion. The first portion may contact the common source line contact plug 380, the channel structure 13, the cell contact plugs 346 and 347, and the input and output contact plug 303, and the second portion may function as a wire for connecting between the common source line layer 320 connected to the common source line contact plug 380 and the common source line layer 320 connected to the channel structure 13. The term "contact" as used herein refers to a direct connection, e.g., touching. The first portion may have a horizontal cross-sectional area that is widest where it abuts the interlayer insulation membrane 20 and narrows as it approaches the second portion. The second portion may have a horizontal cross-sectional area that is widest where it abuts the first portion and narrows as it goes away from the first portion.

Referring again to FIG. 2, the second substrate 310 covering the common source line layer 320, the isolated pads 15, and the input and output pads 17 may be formed by adhering a substrate or depositing an insulation layer, and the external pads 305 and 306 may be formed on the second substrate 310, thereby the memory device according to an embodiment being manufactured.

By the above described method, the common source line layer 320, the isolated pads 15, and the input and output pads 17 may be formed together with a metal.

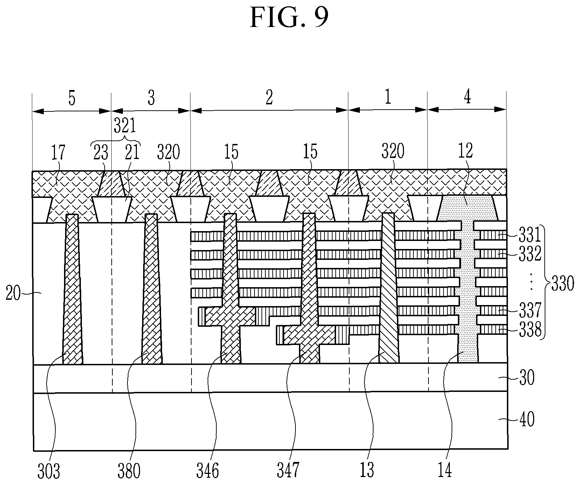

FIG. 9 shows a method for manufacturing a semiconductor device according to another embodiment.

Referring to FIG. 9, a dual damascene process may be applied as a substitute of the process described with reference to FIG. 7 and FIG. 8. For example, after the process shown in FIG. 6 being performed, the pattern of the insulation layer 23 is formed, a barrier metal is deposited, the metal layer of copper may be conformally formed by electroplating and may be planarized by CMP, thereby forming the common source line layer 320, the isolated pads 15, and the input and output pads 17 as shown in FIG. 9.

Referring to FIG. 9, the common source line layer 320, the isolated pads 15, and the input and output pads 17 may include a first portion filling a space where the sacrificial layer 11 is removed and a second portion formed on the first portion. The second portion may function as a wire for connecting between the common source line layer 320 connected to the common source line contact plug 380 and the common source line layer 320 connected to the channel structure 13. The first portion may have a horizontal cross-sectional area that is widest where it abuts the interlayer insulation layer 20 and narrows as it approaches the second portion. The second portion may have a horizontal cross-sectional area that is narrowest where it abuts the first portion and widens as it goes away from the first portion.

As described above, according to an embodiment, the common source line layer 320, the isolated pads 15, and the input and output pads 17 may be formed together, and the common source line layer 320 may be made of a metal, thereby simplifying the structure of the semiconductor device and the manufacturing process.

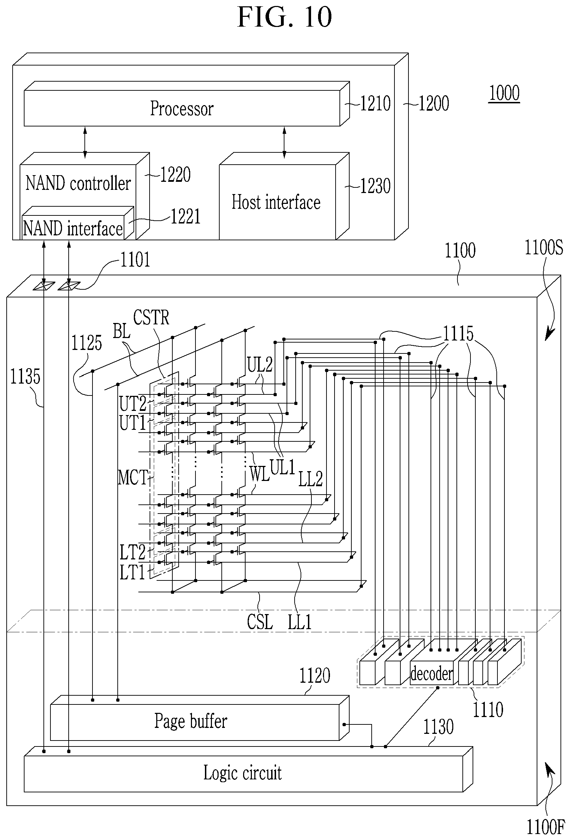

FIG. 10 shows a data storage system including a semiconductor device according to an embodiment.

Referring to FIG. 10, the data storage system 1000 may include a semiconductor device 1100 and a controller 1200 electrically connected to the semiconductor device 1100. The data storage system 1000 may be a storage device including one or multiple semiconductor devices 1100 or an electronic device including a storage device. For example, the data storage system 1000 may be a solid state drive (SSD) device, a universal serial bus (USB) device, a computing system, a medical device, or a communication device including one or multiple semiconductor devices 1100.

The semiconductor device 1100 may be a non-volatile memory device, for example, the memory device described with reference to FIG. 1 to FIG. 9. The semiconductor device 1100 may include a first semiconductor structure 1100F and a second semiconductor structure 1100S disposed on the first semiconductor structure 1100F. The first semiconductor structure 1100F and the second semiconductor structure 1100S may correspond to the lower chip and the upper chip of FIG. 2, respectively. The first semiconductor structure 1100F may be a peripheral circuit structure including a decoder circuit 1110, a page buffer 1120, and a logic circuit 1130. The second semiconductor structure 1100S may be a memory cell structure including a bit line BL, a common source line CSL, word lines WL, first and second gate upper lines UL1 and UL2, first and second gate lower lines LL1 and LL2, and memory cell strings CSTR between the bit line BL and the common source line CSL.

Regarding the second semiconductor structure 1100S, the respective memory cell strings CSTR may include lower transistors LT1 and LT2 disposed near the common source line CSL, upper transistors UT1 and UT2 disposed near the bit line BL, and memory cell transistors MCT disposed between the lower transistors LT1 and LT2 and the upper transistors UT1 and UT2. The number of the lower portion transistors LT1 and LT2 and the number of the upper transistors UT1 and UT2 are modifiable in many ways depending on embodiments.

In the embodiments, the upper transistors UT1 and UT2 may include string selecting transistors, and the lower transistors LT1 and LT2 may include ground selecting transistors. The gate lower lines LL1 and LL2 may be gate electrodes of the lower transistors LT1 and LT2. The word lines WL may be gate electrodes of the memory cell transistors MCT, and the gate upper lines UL1 and UL2 may be gate electrodes of the upper transistors UT1 and UT2.

The lower transistors LT1 and LT2 may include a lower erase controlling transistor LT1 and a ground selecting transistor LT2 connected in series. The upper transistors UT1 and UT2 may include a string selecting transistor UT1 and an upper erase controlling transistor UT2 connected in series. At least one of the lower erase controlling transistor LT1 and the upper erase controlling transistor UT2 may be used in an erase operation for erasing data stored in the memory cell transistors MCT by using a GIDL phenomenon.

The common source line CSL, the first and second gate lower lines LL1 and LL2, the word lines WL, and the first and second gate upper lines UL1 and UL2 may be electrically connected to the decoder circuit 1110 through first connection wires 1115 extending to the second semiconductor structure 1100S from the first semiconductor structure 1100F. The first connection wires 1115 may correspond to the cell contact plugs 340, the first metal wires 230b and 350b, the second metal wires 240b and 360b, the upper bonding metals 270b and 370b of FIG. 2. The bit lines BL may be electrically connected to the page buffer 1120 through second connection wires 1125 extending to the second semiconductor structure 1100S from the first semiconductor structure 1100F.

The first semiconductor structure 1100F, the decoder circuit 1110, and the page buffer 1120 may perform a control operation on at least one of the memory cell transistors MCT. The decoder circuit 1110 and the page buffer 1120 may be controlled by the logic circuit 1130. The semiconductor device 1100 may communicate with the controller 1200 through an input and output pad 1101 electrically connected to the logic circuit 1130. The input and output pad 1101 may correspond to the input and output pad 17 of FIG. 2. The input and output pad 1101 may be electrically connected to the logic circuit 1130 through an input and output connection wire 1135 extending to the second semiconductor structure 1100S from the first semiconductor structure 1100F. The input and output connection wire 1135 may correspond to the second input and output contact plug 303 or the third input and output contact plug 304, and the upper metal patterns 272a and 372a of FIG. 2.

The controller 1200 may include a processor 1210, a NAND controller 1220, and a host interface 1230. Depending on embodiments, the data storage system 1000 may include a plurality of semiconductor devices 1100, and in this case, the controller 1200 may control the semiconductor devices 1100.

The processor 1210 may control an entire operation of the data storage system 1000 including the controller 1200. The processor 1210 may be operable according to predetermined firmware, and may control the NAND controller 1220 to access the semiconductor device 1100. The NAND controller 1220 may include a NAND interface 1221 for processing communication with the semiconductor device 1100. Control instructions for controlling the semiconductor device 1100, data to be written to the memory cell transistors MCT of the semiconductor device 1100, and data to be read from the memory cell transistors MCT of the semiconductor device 1100 may be transmitted through the NAND interface 1221. The host interface 1230 may provide a communication function between the data storage system 1000 and an external host. When receiving the control instruction from the external host through the host interface 1230, the processor 1210 may control the semiconductor device 1100 in response to the control instruction.

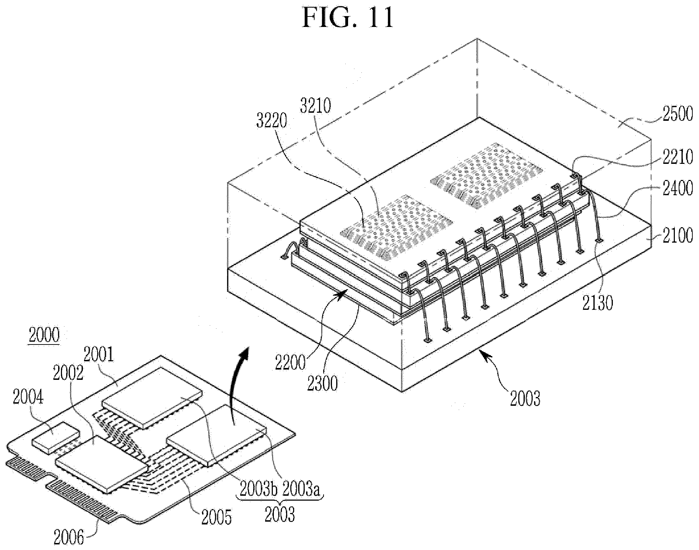

FIG. 11 shows a perspective view of a data storage system including a semiconductor device according to an embodiment.

Referring to FIG. 11, the data storage system 2000 may include a main substrate 2001, a controller 2002, at least one semiconductor package 2003, and a DRAM 2004, which are provided on the main substrate 2001. The semiconductor package 2003 and the DRAM 2004 may be connected to the controller 2002 by wire patterns 2005 formed on the main substrate 2001.

The main substrate 2001 may include a connector 2006 including pins for coupling with an external host. The number of the pins of the connector 2006 and the disposition thereof may be changed depending on the communication interface between the data storage system 2000 and the external host. The data storage system 2000 may communicate with the external host with one of the interfaces such as a universal serial bus (USB), a peripheral component interconnect express (PCI-Express), a serial advanced technology attachment (SATA), or an M-PHY for a universal flash storage (UFS). The data storage system 2000 may be operated by a power voltage supplied by the external host through the connector 2006. The data storage system 2000 may further include a power management integrated circuit (PMIC) for providing the power voltage supplied by the external host to the controller 2002 and the semiconductor package 2003.

The controller 2002 may write data to the semiconductor package 2003, may read data from the semiconductor package 2003, and may increase an operation rate of the data storage system 2000.

The DRAM 2004 may be a buffer memory for reducing a speed difference between the semiconductor package 2003 that is a data storage space and the external host. The DRAM 2004 included in the data storage system 2000 may work as a cache memory, and may provide a space for temporarily storing data in an operation for controlling the semiconductor package 2003. When the data storage system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced from each other. The first and second semiconductor packages 2003a and 2003b may respectively include a plurality of semiconductor chips 2200. The first and second semiconductor packages 2003a and 2003b may respectively include a package substrate 2100, semiconductor chips 2200 disposed on the package substrate 2100, adhesive layers 2300 disposed at bottom surfaces of the semiconductor chips 2200, a connection structure 2400 for electrically connecting the semiconductor chips 2200 and the package substrate 2100, and a molding layer 2500 for covering the semiconductor chips 2200 and the connection structure 2400 on the package substrate 2100.

The package substrate 2100 may be a flexible printed circuit (FPC) including package upper pads 2130. The respective semiconductor chips 2200 may include an input and output pad 2210. The input and output pad 2210 may correspond to the input and output pad 1101 of FIG. 10. The respective semiconductor chips 2200 may include gate stacking structures 3210 and channel structures 3220. The respective semiconductor chips 2200 may include the semiconductor device described with reference to FIG. 1 to FIG. 9.

The connection structure 2400 may be a bonding wire for electrically connecting the input and output pad 2210 and the package upper pads 2130. Therefore, regarding the first and second semiconductor packages 2003a and 2003b, the semiconductor chips 2200 may be electrically connected to each other by a bonding wire, and may be electrically connected to the package upper pads 2130 of the package substrate 2100. The semiconductor chips 2200 may be electrically connected to each other by the connection structure including a through substrate via (e.g., a through silicon via (TSV)) instead of the connection structure 2400 based on the bonding wire method. In example embodiments, the semiconductor chips 2200 may be electrically connected to each other by the connection structure including the TSV and the connection structure 2400.

The controller 2002 and the semiconductor chips 2200 may be included in one package. Depending on embodiments, the controller 2002 and the semiconductor chips 2200 may be mounted on an interposer substrate that is not the main substrate 2001, and the controller 2002 may be connected to the semiconductor chips 2200 by the wire formed on the interposer substrate.

While this disclosure has been described in connection with what is presently considered to be practical embodiments, it is to be understood that the disclosure is not limited to the disclosed embodiments, but, on the contrary, is intended to cover various modifications included within the scope of the present invention as defined by the appended claims.

## Claims

1. A semiconductor device comprising:
a cell region (1) including:
word lines (330 - 338);
a channel structure (CH) penetrating through the word lines; and
memory cells connected to the word lines and arranged in three dimensions;
a cell contact region (2) having a cell contact plug (340) connected to a word line of the cell region;
a common source line contact region (3) having a common source line contact plug (380);
an input and output contact region (5) having an input and output contact plug (203) connected to a circuit (220a - 220c) of the semiconductor device;
a word line cut region (4) to separate the word lines of the cell region from word lines of a neighboring cell region;
a common source line layer (320) connecting the channel structure of the cell region and the common source line contact plug; and
an input and output pad (17) as an external pad of the semiconductor device connected to the input and output contact plug,
wherein the common source line layer and the input and output pad are disposed at the same vertical level, and
wherein the common source line layer and the input and output pad comprise the same material,
the semiconductor device further comprising:
an isolated pad (15) disposed in the cell contact region (2) and connected to the cell contact plug (340),
wherein the isolated pad is disposed at the same vertical level as the common source line layer (320), and
wherein the isolated pad and the common source line layer comprise the same material.

2. The semiconductor device of claim 1, wherein the common source line layer (320) comprises a metal as a major component.

3. The semiconductor device of claim 1 or 2, wherein the common source line layer (320) is disposed across, and integrally formed with, the cell region (1), the common source line contact region (3) and the word line cut region (4).

4. The semiconductor device of claim 3, wherein the isolated pad (15) is surrounded by the common source line layer (320).

5. The semiconductor device of claim 3 or 4, wherein the common source line layer (320), the input and output pad (1101) and the isolated pad (15) are embedded in an insulation layer (23).

6. The semiconductor device of claim 5, wherein the insulation layer (23) includes an upper layer and a lower layer formed of the same material.

7. The semiconductor device of claim 5, wherein the insulation layer (23) includes an upper layer and a lower layer formed of a different material from the upper layer.

8. The semiconductor device of claim 6 or 7, wherein the lower layer of the insulation layer comprises a silicon oxide.

9. The semiconductor device of any of claims 6 to 8, wherein the upper layer and the lower layer of the insulation layer (15) have different cross-sectional shapes.

10. The semiconductor device of any one of claims 3 to 9, wherein:
each of the common source line layer (320), the isolated pad (15), and the input and output pad (1101) includes a first portion contacting the channel structure (CH), the common source line contact plug (380), the cell contact plug (340) and the input and output contact plug (203), and a second portion disposed on the first portion;
the first portion has a horizontal cross-sectional area that is widest where it abuts the channel structure (CH), the common source line contact plug (380), the cell contact plug (340) and the input and output contact plug (203), and that narrows as it approaches the second portion; and
the second portion has a horizontal cross-sectional area that is widest where it abuts the first portion and narrows as it goes away from the first portion.

11. The semiconductor device of any one of claims 3 to 9, wherein:
each of the common source line layer (320), the isolated pad (15), and the input and output pad (1101) includes a first portion contacting the channel structure (CH), the common source line contact plug (380), the cell contact plug (340) and the input and output contact plug (203), and a second portion disposed on the first portion;
the first portion has a horizontal cross-sectional area that is widest where it abuts the channel structure (CH), the common source line contact plug (380), the cell contact plug (340) and the input and output contact plug (203), and that narrows as it approaches the second portion; and
the second portion has a horizontal cross-sectional area that is narrowest where it abuts the first portion and widens as it goes away from the first portion.

12. A method of manufacturing a semiconductor device of any preceding claim, the method comprising:
forming a sacrificial layer (11) in a trench formed in a silicon substrate (10);
forming a memory cell structure on a cell region (1) of the silicon substrate in which the sacrificial layer is formed;
removing the silicon substrate, forming a first insulation layer (21) to cover the sacrificial layer, and partially removing the first insulation layer (21) to expose an upper surface of the sacrificial layer;
removing the sacrificial layer; and
forming a metal layer (320') filling a space where the sacrificial layer is removed, and patterning the metal layer,
wherein the forming of the memory cell structure comprises:
forming a channel structure (13) penetrating through a plurality of word lines (330);
forming a cell contact plug (340) connected to a word line of the plurality of word lines;
forming a common source line contact plug (380) connected to the channel structure;
forming an input and output contact plug (203) connected to a circuit (40) of the semiconductor device; and
forming a word line cut insulator to separate the plurality of word lines of the cell region from word lines of a neighboring cell region of the silicon substrate.

13. The method of claim 12, wherein the forming and patterning of the metal layer (320') includes:
forming a common source line layer (320) connected to the channel structure (CH) and the common source line contact plug (380);
forming an input and output pad (1101) as an external pad of the semiconductor device connected to the input and output contact plug (203); and
forming an isolated pad connected to the cell contact plug (340).

## Patentansprüche

1. Halbleitervorrichtung, umfassend:
einen Zellbereich (1), der Folgendes einschließt:
Wortleitungen (330 - 338);
eine Kanalstruktur (CH), die die Wortleitungen durchdringt; und
Speicherzellen, die mit den Wortleitungen verbunden und dreidimensional angeordnet sind;
einen Zellenkontaktbereich (2), der einen Zellenkontaktstecker (340) aufweist, der mit einer Wortleitung des Zellbereichs verbunden ist;
einen gemeinsamen Quellleitungskontaktbereich (3), der einen gemeinsamen Quellleitungskontaktstecker (380) aufweist;
einen Eingabe- und Ausgabekontaktbereich (5), der einen Eingabe- und Ausgabekontaktstecker (203) aufweist, der mit einem Schaltkreis (220a - 220c) der Halbleitervorrichtung verbunden ist;
einen Wortleitungsschnittbereich (4), um die Wortleitungen des Zellbereichs von Wortleitungen eines angrenzenden Zellbereichs zu trennen;
eine gemeinsame Quellleitungsschicht (320), die die Kanalstruktur des Zellbereichs und den gemeinsamen Quellleitungskontaktstecker verbindet; und
ein Eingabe- und Ausgabepad (17) als externes Pad der Halbleitervorrichtung, das mit dem Eingabe- und Ausgabekontaktstecker verbunden ist,
wobei die gemeinsame Quellleitungsschicht und das Eingabe- und Ausgabepad auf derselben vertikalen Ebene angeordnet sind, und
wobei die gemeinsame Quellleitungsschicht und das Eingabe- und Ausgabepad das gleiche Material umfassen,
wobei die Halbleitervorrichtung weiter Folgendes umfasst:
ein isoliertes Pad (15), das im Zellenkontaktbereich (2) angeordnet und mit dem Zellenkontaktstecker (340) verbunden ist,
wobei das isolierte Pad auf der gleichen vertikalen Ebene wie die gemeinsame Quellleitungsschicht (320) angeordnet ist, und
wobei das isolierte Pad und die gemeinsame Quellleitungsschicht das gleiche Material umfassen.

2. Halbleitervorrichtung nach Anspruch 1, wobei die gemeinsame Quellleitungsschicht (320) ein Metall als Hauptkomponente umfasst.

3. Halbleitervorrichtung nach Anspruch 1 oder 2, wobei die gemeinsame Quellleitungsschicht (320) über den Zellbereich (1), den gemeinsamen Quellleitungskontaktbereich (3) und den Wortleitungsschnittbereich (4) hinweg angeordnet und mit diesen integral gebildet ist.

4. Halbleitervorrichtung nach Anspruch 3, wobei das isolierte Pad (15) von der gemeinsamen Quellleitungsschicht (320) umgeben ist.

5. Halbleitervorrichtung nach Anspruch 3 oder 4, wobei die gemeinsame Quellleitungsschicht (320), das Eingabe- und Ausgabepad (1101) und das isolierte Pad (15) in eine Isolierschicht (23) eingebettet sind.

6. Halbleitervorrichtung nach Anspruch 5, wobei die Isolierschicht (23) eine obere Schicht und eine untere Schicht einschließt, die aus dem gleichen Material gebildet sind.

7. Halbleitervorrichtung nach Anspruch 5, wobei die Isolierschicht (23) eine obere Schicht und eine untere Schicht umfasst, die aus einem anderen Material als die obere Schicht gebildet ist.

8. Halbleitervorrichtung nach Anspruch 6 oder 7, wobei die untere Schicht der Isolierschicht ein Siliziumoxid umfasst.

9. Halbleitervorrichtung nach einem der Ansprüche 6 bis 8, wobei die obere Schicht und die untere Schicht der Isolierschicht (15) unterschiedliche Querschnittsformen aufweisen.

10. Halbleitervorrichtung nach einem der Ansprüche 3 bis 9, wobei:
jedes der gemeinsamen Quellleitungsschicht (320), des isolierten Pads (15) und des Eingabe- und Ausgabepads (1101) einen ersten Abschnitt einschließt, der mit der Kanalstruktur (CH), dem gemeinsamen Quellleitungskontaktstecker (380), dem Zellenkontaktstecker (340) und dem Eingabe- und Ausgabekontaktstecker (203) in Kontakt steht, und einen zweiten Abschnitt, der auf dem ersten Abschnitt angeordnet ist;
der erste Abschnitt eine horizontale Querschnittsfläche aufweist, die dort am breitesten ist, wo sie an die Kanalstruktur (CH), den gemeinsamen Quellleitungskontaktstecker (380), den Zellenkontaktstecker (340) und den Eingabe- und Ausgabekontaktstecker (203) anstößt, und sich verengt, je mehr sie sich dem zweiten Abschnitt nähert; und
der zweite Abschnitt eine horizontale Querschnittsfläche aufweist, die dort am breitesten ist, wo sie an den ersten Abschnitt anstößt, und sich verengt, je weiter sie sich vom ersten Abschnitt entfernt.

11. Halbleitervorrichtung nach einem der Ansprüche 3 bis 9, wobei:
jedes der gemeinsamen Quellleitungsschicht (320), des isolierten Pads (15) und des Eingabe- und Ausgabepads (1101) einen ersten Abschnitt einschließt, der mit der Kanalstruktur (CH), dem gemeinsamen Quellleitungskontaktstecker (380), dem Zellenkontaktstecker (340) und dem Eingabe- und Ausgabekontaktstecker (203) in Kontakt steht, und einen zweiten Abschnitt, der auf dem ersten Abschnitt angeordnet ist;
der erste Abschnitt eine horizontale Querschnittsfläche aufweist, die dort am breitesten ist, wo sie an die Kanalstruktur (CH), den gemeinsamen Quellleitungskontaktstecker (380), den Zellenkontaktstecker (340) und den Eingabe- und Ausgabekontaktstecker (203) anstößt, und sich verengt, je mehr sie sich dem zweiten Abschnitt nähert; und
der zweite Abschnitt eine horizontale Querschnittsfläche aufweist, die dort am engsten ist, wo sie an den ersten Abschnitt anstößt, und sich verbreitert, je weiter sie sich vom ersten Abschnitt entfernt.

12. Verfahren zur Herstellung einer Halbleitervorrichtung nach einem vorstehenden Anspruch, wobei das Verfahren Folgendes umfasst:
Bilden einer Opferschicht (11) in einer Rinne, die in einem Siliziumsubstrat (10) gebildet ist;
Bilden einer Speicherzellenstruktur auf einem Zellbereich (1) des Siliziumsubstrats, in dem die Opferschicht gebildet ist;
Entfernen des Siliziumsubstrats, Bilden einer ersten Isolierschicht (21) zum Abdecken der Opferschicht und teilweises Entfernen der ersten Isolierschicht (21) zum Freilegen einer oberen Oberfläche der Opferschicht;
Entfernen der Opferschicht; und
Bilden einer Metallschicht (320'), die einen Raum füllt, in dem die Opferschicht entfernt wurde, und Strukturieren der Metallschicht,
wobei das Bilden der Speicherzellenstruktur Folgendes umfasst:
Bilden einer Kanalstruktur (13), die eine Vielzahl von Wortleitungen (330) durchdringt;
Bilden eines Zellenkontaktsteckers (340), der mit einer Wortleitung der Vielzahl von Wortleitungen verbunden ist;
Bilden eines gemeinsamen Quellleitungskontaktsteckers (380), der mit der Kanalstruktur verbunden ist;
Bilden eines Eingabe- und Ausgabekontaktsteckers (203), der mit einem Schaltkreis (40) der Halbleitervorrichtung verbunden ist; und
Bilden eines Wortleitungsschnittisolators zum Trennen der Vielzahl von Wortleitungen des Zellbereichs von Wortleitungen eines benachbarten Zellbereichs des Siliziumsubstrats.

13. Verfahren nach Anspruch 12, wobei das Bilden und Strukturieren der Metallschicht (320') Folgendes umfasst:
Bilden einer gemeinsamen Quellleitungsschicht (320), die mit der Kanalstruktur (CH) und dem gemeinsamen Quellleitungskontaktstecker (380) verbunden ist;
Bilden eines Eingabe- und Ausgabepads (1101) als externes Pad der Halbleitervorrichtung, das mit dem Eingabe- und Ausgabekontaktstecker (203) verbunden ist; und
Bilden eines isolierten Pads, das mit dem Zellenkontaktstecker (340) verbunden ist.

## Revendications

1. Dispositif semi-conducteur comprenant :
une région de cellules (1) incluant :
des lignes de mots (330 - 338) ;
une structure de canaux (CH) pénétrant à travers les lignes de mots ; et
des cellules de mémoire connectées aux lignes de mots et agencées en trois dimensions ;
une région de contact de cellules (2) présentant une fiche de contact de cellules (340) connectée à une ligne de mots de la région de cellules ;
une région de contact de ligne de source commune (3) présentant une fiche de contact de ligne de source commune (380) ;
une région de contact d'entrée et de sortie (5) présentant une fiche de contact d'entrée et de sortie (203) connectée à un circuit (220a - 220c) du dispositif semi-conducteur ;
une région de découpe de ligne de mots (4) pour séparer les lignes de mots de la région de cellules de lignes de mots d'une région de cellules voisine ;
une couche de ligne de source commune (320) connectant la structure de canaux de la région de cellules et la fiche de contact de ligne de source commune ; et
une pastille d'entrée et de sortie (17) servant de pastille externe du dispositif semi-conducteur connectée à la fiche de contact d'entrée et de sortie,
dans lequel la couche de ligne de source commune et la pastille d'entrée et de sortie sont disposées au même niveau vertical, et
dans lequel la couche de ligne de source commune et la pastille d'entrée et de sortie sont constitués du même matériau,
le dispositif semi-conducteur comprenant en outre :
une pastille isolée (15) disposée dans la région de contact de cellules (2) et connectée à la fiche de contact de cellules (340),
dans lequel la pastille isolée est disposée au même niveau vertical que la couche de ligne de source commune (320), et
dans lequel la pastille isolée et la couche de ligne de source commune sont constituées du même matériau.

2. Dispositif semi-conducteur selon la revendication 1, dans lequel la couche de ligne de source commune (320) comprend un métal comme composant principal.

3. Dispositif semi-conducteur selon la revendication 1 ou 2, dans lequel la couche de ligne de source commune (320) est disposée à travers et formée intégralement avec la région de cellules (1), la région de contact de ligne de source commune (3) et la région de découpe de ligne de mots (4).

4. Dispositif semi-conducteur selon la revendication 3, dans lequel la pastille isolée (15) est entourée par la couche de ligne de source commune (320).

5. Dispositif semi-conducteur selon la revendication 3 ou 4, dans lequel la couche de ligne de source commune (320), la pastille d'entrée et de sortie (1101) et la pastille isolée (15) sont intégrées dans une couche d'isolation (23).

6. Dispositif semi-conducteur selon la revendication 5, dans lequel la couche d'isolation (23) inclut une couche supérieure et une couche inférieure formées du même matériau.

7. Dispositif semi-conducteur selon la revendication 5, dans lequel la couche d'isolation (23) inclut une couche supérieure et une couche inférieure formées d'un matériau différent de la couche supérieure.

8. Dispositif semi-conducteur selon la revendication 6 ou 7, dans lequel la couche inférieure de la couche d'isolation comprend un oxyde de silicium.

9. Dispositif semi-conducteur selon l'une quelconque des revendications 6 à 8, dans lequel la couche supérieure et la couche inférieure de la couche d'isolation (15) présentent des formes de section transversale différentes.

10. Dispositif semi-conducteur selon l'une quelconque des revendications 3 à 9, dans lequel :
chacune de la couche de ligne de source commune (320), de la pastille isolée (15) et de la pastille d'entrée et de sortie (1101) inclut une première partie venant en contact avec la structure de canaux (CH), la fiche de contact de ligne de source commune (380), la fiche de contact de cellules (340) et la fiche de contact d'entrée et de sortie (203), et une seconde partie disposée sur la première partie ;
la première partie présente une section transversale horizontale qui est la plus large à l'endroit au niveau duquel elle jouxte la structure de canaux (CH), la fiche de contact de ligne de source commune (380), la fiche de contact de cellules (340) et la fiche de contact d'entrée et de sortie (203), et qui rétrécit à mesure qu'elle s'approche de la seconde partie ; et
la seconde partie présente une section transversale horizontale qui est la plus large à l'endroit au niveau duquel elle jouxte la première partie et qui rétrécit à mesure qu'elle s'éloigne de la première partie.

11. Dispositif semi-conducteur selon l'une quelconque des revendications 3 à 9, dans lequel :
chacune de la couche de ligne de source commune (320), de la pastille isolée (15) et de la pastille d'entrée et de sortie (1101) inclut une première partie venant en contact avec la structure de canaux (CH), la fiche de contact de ligne de source commune (380), la fiche de contact de cellules (340) et la fiche de contact d'entrée et de sortie (203), et une seconde partie disposée sur la première partie ;
la première partie présente une section transversale horizontale qui est la plus large à l'endroit au niveau duquel elle jouxte la structure de canaux (CH), la fiche de contact de ligne de source commune (380), la fiche de contact de cellules (340) et la fiche de contact d'entrée et de sortie (203), et qui rétrécit à mesure qu'elle s'approche de la seconde partie ; et
la seconde partie présente une section transversale horizontale qui est la plus étroite à l'endroit au niveau duquel elle jouxte la première partie et qui s'élargit à mesure qu'elle s'éloigne de la première partie.

12. Procédé de fabrication d'un dispositif à semi-conducteur selon une quelconque revendication précédente, le procédé comprenant les étapes consistant à :
former une couche sacrificielle (11) dans une tranchée formée dans un substrat de silicium (10) ;
former une structure de cellules de mémoire sur une région de cellules (1) du substrat de silicium dans lequel la couche sacrificielle est formée ;
enlever le substrat de silicium, former une première couche d'isolation (21) pour recouvrir la couche sacrificielle, et enlever partiellement la première couche d'isolation (21) pour exposer une surface supérieure de la couche sacrificielle ;
enlever la couche sacrificielle ; et
former une couche de métal (320') remplissant un espace au niveau duquel la couche sacrificielle est enlevée, et structurer la couche de métal,
dans lequel la formation de la structure de cellules de mémoire comprend les étapes consistant à :
former une structure de canaux (13) pénétrant à travers une pluralité de lignes de mots (330) ;
former une fiche de contact de cellules (340) connectée à une ligne de mots de la pluralité de lignes de mots ;
former une fiche de contact de ligne de source commune (380) connecté à la structure de canaux ;
former une fiche de contact d'entrée et de sortie (203) connectée à un circuit (40) du dispositif à semi-conducteur; et
former un isolateur de découpe de ligne de mots pour séparer la pluralité de lignes de mots de la région de cellules des lignes de mots d'une région de cellules voisine du substrat de silicium.

13. Procédé selon la revendication 12, dans lequel la formation et la structuration de la couche de métal (320') incluent les étapes consistant à :
former une couche de ligne de source commune (320) connectée à la structure de canaux (CH) et à la fiche de contact de ligne de source commune (380) ;
former une pastille d'entrée et de sortie (1101) servant de pastille externe du dispositif à semi-conducteur connectée à la fiche de contact d'entrée et de sortie (203) ; et
former une pastille isolée connectée à la fiche de contact de cellules (340).
